Europäisches Patentamt

European Patent Office

Office européen des brevets

(19)

(11) Veröffentlichungsnummer : **0 152 581**
**B1**

(12) # EUROPÄISCHE PATENTSCHRIFT

(45) Veröffentlichungstag der Patentschrift :
27.07.88

(51) Int. Cl.⁴ : **H 03 F 3/72**

(21) Anmeldenummer : **84115209.3**

(22) Anmeldetag : **12.12.84**

(54) Gleichstromgekoppelter Verstärker.

(30) Priorität : **10.02.84 DE 3404719**

(43) Veröffentlichungstag der Anmeldung :
**28.08.85 Patentblatt 85/35**

(45) Bekanntmachung des Hinweises auf die Patenterteilung : **27.07.88 Patentblatt 88/30**

(84) Benannte Vertragsstaaten :
**AT DE FR GB**

(56) Entgegenhaltungen :
**FR-A- 2 260 902**
**US-A- 3 747 007**
**US-A- 4 386 378**
**SIEMENS INTEGRIERTE SCHALTUNGEN FÜR INDUS-
TRIELLE ANWENDUNGEN, 1982/83, Seiten 177-184**

(73) Patentinhaber : **ROBERT BOSCH GMBH**
**Postfach 50**
**D-7000 Stuttgart 1 (DE)**

(72) Erfinder : **Gorzel, Heribert, Dipl.-Ing.**
**Forstweg 33 c**
**D-1000 Berlin 28 (DE)**
Erfinder : **Liess, Wolfgang, Dipl.-Ing.**
**Jägerndorfer Zeile 39**
**D-1000 Berlin 45 (DE)**

(74) Vertreter : **Schmidt, Hans-Ekhardt**
**Robert Bosch GmbH Geschäftsbereich Elektronik**
**Patent- und Lizenzabteilung Forckenbeckstrasse 9-
13**
**D-1000 Berlin 33 (DE)**

## Beschreibung

### Stand der Technik

Die Erfindung geht von einem gleichstromgekoppelten Verstärker nach der im Oberbegriff des Anspruchs 1 angegebenen Gattung aus.

Es ist schon ein gleichstromgekoppelter Verstärker bekannt (Siemens, Integrierte Schaltungen für industrielle Anwendungen, 1982/83, Seiten 177 bis 184), der eine interne Gleichstromgegenkopplung und einen äußeren Kondensator zur Hochfrequenzabblockung am Anschluß für die Arbeitspunkteinstellung des Verstärkers aufweist. Es hat sich herausgestellt, daß die Zeitkonstante des im Gegenkopplungsweg liegenden RC-Gliedes für verschiedene Anwendungen des Verstärkers zu groß ist. Gehört der Verstärker beispielsweise zu einem batteriebetriebenen Funkgerät, bei dem die Gleichstromversorgung mit Ausnahme der Versorgung für eine Mikroprozessorschaltung aus Stromersparnisgründen in einem bestimmten Rhythmus geschaltet wird, so bedeutet die bei jedem Einschalten auftretende Einschwingzeit des Verstärkers einen Verlust an nutzbarer Empfangszeit für das Funkgerät und damit einen unnötigen Stromverbrauch.

### Vorteile der Erfindung

Der erfindungsgemäße gleichstromgekoppelte Verstärker mit den kennzeichnenden Merkmalen des Anspruchs 1 hat den Vorteil, daß der gleichstromgekoppelte Verstärker sehr schnell einschwingt und damit eine bessere Ausnutzung der Batteriekapazität ermöglicht, die insbesondere für tragbare Funkempfänger von Großer Bedeutung ist.

### Zeichnung

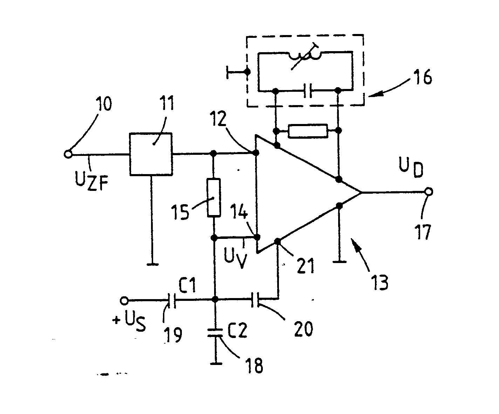

Ein Ausführungsbeispiel der Erfindung ist in der Zeichnung an Hand einer einzigen Figur dargestellt und in der nachfolgenden Beschreibung näher erläutert.

### Beschreibung der Erfindung

In der Figur ist ein Ausschnitt aus dem Zwischenfrequenzteil einer Funkgeräteschaltung gezeigt, in welcher 10 einen Anschluß für eine Zwischenfrequenzspannung $U_{ZF}$ bezeichnet. Der Anschluß 10 steht über ein Zwischenfrequenzfilter 11 mit einem ersten Eingang 12 eines als integrierte Schaltung ausgebildeten Zwischenfrequenzverstärkers 13 in Verbindung, der intern gleichstromgegenkoppelt ist. Zwischen dem ersten Eingang 12 und einem zweiten Eingang 14 des Verstärkers, dem das Vorspannungspotential $U_V$ zugeführt wird, liegt ein Widerstand 15. Zu dem Verstärker gehört ein Diskriminator, dessen äußere Beschaltung mit 16 bezeichnet ist. Der Verstärker weist einen Ausgang 17 auf. Der zweite Eingang 14 des Verstärkers steht über einen ersten Kondensator 18 mit Masse, über einen zweiten Kondensator 19 mit einem geschalteten positiven Potential $U_S$ und über inen dritten Kondensator 20 mit einem Anschluß 21 des Verstärkers in Verbindung. Der Verstärker wird in bekannten Weise aus einer der Übersichtlichkeit halber in der Zeichnung nicht dargestellten Betriebsgleichstromquelle (Batterie) gespeist.

Die Wirkungsweise der vorstehend beschriebenen Schaltung ist folgende.

Damit die Zeitkonstante der als RC-Glied realisierten internen Gleichstromgegenkopplung nicht zu einer Großen Einschwingzeit des Verstärkers 13 führt, wird das Verhältnis der Kapazitätswerte C1, C2 der Kondensatoren 19, 18 derart gewählt, daß durch das schlagartige Aufladen dieser Kondensatoren bei in einem bestimmten Rhythmus erfolgendem Einschalten der Gleichspannung $U_S$ nahezu unverzögert an dem zweiten Eingang 14 des Verstärkers 13 die für den Verstärker vorgesehene Arbeitspunktspannung $U_V$ ansteht. Die mit dem Zwischenfrequenzfilter 11 selektierte und durch den Verstärker 13 zu verstärkende und zu demodulierende ZF-Spannung $U_{ZF}$ steht somit nach jedem Einschalten der Spannung $U_S$ fast unverzögert am Ausgang 17 des Verstärkers 13 als demodulierte Spannung $U_D$ zur Verfügung. Mit dem jeweiligen Abschalten der Gleichspannung $U_S$ entladen sich die Kondensatoren 18 und 19, so daß sie sich beim nachfolgenden Wiedereinschalten der Gleichspannung im entladenen Zustand befinden.

Die Erfindung ist nicht auf den als Ausführungsbeispiel gewählten Zwischenfrequenzverstärker beschränkt ; si kann mit gleichem Vorteil auch bei anderen Verstärkern, zum Beispiel auch bei einem Komparator, angewendet werden.

## Patentanspruch

Gleichstromgekoppelter Verstärker (13), dessen Arbeitspunkt aus Stabilitätsgründen mittels eines zwischen einem Ausgang der Verstärkers und einem Eingang (14) für die Arbeitspunktspannung ($U_v$) des Verstärkers geschalteten RC-Tiefpaßfilters das eine zwischen diesem Eingang und Masse verbundene Querkapazität ($C_2$) enthält, erzeugt wird und der durch eine geschaltete versorgungsspannung gespeist wird, dadurch gekennzeichnet, daß an diesem Eingang (14) eine mit dem geschalteten Pluspotential ($U_S$) der Versorgungsspannung verbundene Längskapazität ($C1$) liegt und daß das Verhältnis von Längskapazität und Querkapazität derart gewählt wird, daß bei jedem Einschalten des Pluspotentials die vorgegebene Arbeitspunktspannung nahezu unverzögert eingeprägt wird.

## Claim

A direct-current-coupled amplifier (13) whose operating point is produced, for purposes of stability, by means of an RC low-pass filter, which is connected between an output of the amplifier and an input (14) for the operating point voltage ($U_v$) of the amplifier, which filter contains a shunt capacitance ($C_2$) connected between this input and earth, and which is fed by a switched supply voltage, characterised in that a series capacitance (C1), which is connected to the switched positive potential ($U_S$) of the supply voltage, is applied to this input (14) and the ratio of the series capacitance to the shunt capacitance is selected such that, each time the positive potential is switched on, the predetermined operating point voltage is impressed almost immediately.

**Revendication**

Amplificateur (13), couplé avec du courant continu, dont le point de fonctionnement, pour des raisons de stabilité, est produit au moyen d'un filtre passe-bas RC branché entre une sortie de l'amplificateur et une entrée (14) pour la tension ($U_v$) au point de fonctionnement de l'amplificateur et comportant une capacité transversale ($C_2$), intercalée entre cette entrée et la masse, cet amplificateur étant alimenté par une tension d'alimentation mise en circuit, amplificateur caractérisé en ce que, sur cette entrée (14), est branchée une capacité longitudinale ($C_1$) reliée au potentiel positif ($U_S$) de la tension d'alimentation mis en circuit, et en ce que le rapport entre capacité longitudinale et capacité transversale est choisi de telle manière, que lors de chaque mise en circuit du potentiel positif, la tension prédéterminée au point de fonctionnement est appliquée en étant presque à action instantanée.